# FASCICULE DE BREVET EUROPEEN

(11) **EP 4 107 666 B1**
(45) Date de publication et mention de la délivrance du brevet: **17.12.2025**
(21) Numéro de dépôt: 21705219.0
(22) Date de dépôt: 18.02.2021
(51) Int. Cl.: G06K 19/067, G01S 13/75

(54) **DISPOSITIFS D'IDENTIFICATION PAR FRÉQUENCE RADIO (« RFID ») SANS PUCE**
CHIPLOSES RFID-ETIKETT
CHIPLESS RFID CHIP

(30) Priorité: 20.02.2020 EP 20305162
(43) Date de publication de la demande: 28.12.2022
(73) Titulaire: Idyllic Technology, 26000 Valence (FR)
(72) Inventeur: GAUTIER LE BOULCH, Louis, 92190 Meudon (FR); ABERGEL, Edmond, 75012 Paris (FR)
(74) Mandataire: De Kezel, Eric
(86) Numéro de dépôt international: PCT/EP2021/054069
(87) Numéro de publication internationale: WO 2021/165422

(56) Documents cités:
- EP-A1- 3 537 855
- MA ZHONG-HUA ET AL: "A re-transmitted chipless tag using CSRR coupled structure", MICROSYSTEM TECHNOLOGIES, BERLIN, DE, vol. 24, no. 10, 2 April 2018 (2018-04-02), pages 4373 - 4382, XP036598677, ISSN: 0946-7076, [retrieved on 20180402], DOI: 10.1007/S00542-018-3836-Z
- PEIXEIRO CUSTODIO: "High efficiency aperture-coupled stacked-patch antennas with foam substrate", 2013 IEEE ANTENNAS AND PROPAGATION SOCIETY INTERNATIONAL SYMPOSIUM (APSURSI), IEEE, 7 July 2013 (2013-07-07), pages 1828 - 1829, XP032555894, ISSN: 1522-3965, ISBN: 978-1-4799-3538-3, [retrieved on 20140113], DOI: 10.1109/APS.2013.6711573
- SVANDA MILAN ET AL: "Platform Tolerant, High Encoding Capacity Dipole Array-Plate Chipless RFID Tags", IEEE ACCESS, vol. 7, 14 August 2019 (2019-08-14), pages 138707 - 138720, XP011748327, DOI: 10.1109/ACCESS.2019.2935258
- CORCHIA LAURA ET AL: "A Chipless Humidity Sensor for Wearable Applications", 2019 IEEE INTERNATIONAL CONFERENCE ON RFID TECHNOLOGY AND APPLICATIONS (RFID-TA), IEEE, 25 September 2019 (2019-09-25), pages 174 - 177, XP033648925, DOI: 10.1109/RFID-TA.2019.8892048

## Description

La présente invention concerne un dispositif d'identification par fréquence radio (« RFID ») sans puce (personnalisé), en particulier une étiquette RFID sans puce (personnalisée), aussi appelée « chip-less RFID tag ».

Par « dispositif » il faut comprendre un emballage, un document, notamment un document de sécurité ainsi qu'éventuellement tout objet comprenant l'étiquette RFID sans puce revendiquée.

Les systèmes de transmission de données utilisant la technologie d'identification par fréquence radio sont couramment utilisés pour identifier tous types d'objets et d'êtres vivants (par exemple un animal ou un humain) porteurs d'un dispositif (étiquette) adapté. La technologie RFID est devenue au cours des dernières décennies de plus en plus répandue en tant que dispositif de stockage et de transmission d'informations.

Cette technologie RFID utilise une radio-étiquette, également dénommée transpondeur (de l'anglais « transponder », par contraction des mots « transmitter » et « responder »), qui est placée sur un objet, et un lecteur, également dénommé interrogateur, pour lire et identifier la radio-étiquette. Les technologies RFID sont généralement classées en catégories utilisant des radio-étiquettes « actives » ou « passives ». Les radio-étiquettes actives disposent d'une source d'énergie locale (telle qu'une batterie) grâce à laquelle elles envoient un signal au lecteur ; elles sont ainsi généralement caractérisées par une portée de signal émis relativement longue. En revanche, les radio-étiquettes passives ne disposent pas de source d'alimentation interne car leur énergie d'émission de signal provient du lecteur lui-même, et en particulier de la réception du signal émis par le lecteur ; ainsi, les radio-étiquettes passives ont une portée de signal beaucoup plus faible, en générale inférieure à 8 mètres.

D'un point de vue pratique, la technologie RFID utilise des fréquences radio (« RF ») qui ont des caractéristiques de pénétration du matériau beaucoup plus élevées que les signaux optiques. Ainsi, en comparaison avec les étiquettes codes à barres, la technologie RFID permettra une utilisation dans des conditions environnementales bien plus hostiles ; par exemple, les étiquettes RFID peuvent être lues à travers toute sorte de matière telle que le papier, le carton, le bois, la peinture, l'eau, la saleté, la poussière, le corps animal ou humain, le béton ou encore à travers l'article étiqueté lui-même ou son emballage. Ceci a ouvert aux étiquettes RFID une large gamme d'applications parmi lesquelles nous citerons à titre illustratif, l'identification des biens et des personnes, en particulier des emballages, des voitures (parking, péages, ...), la gestion des inventaires, les cartes d'accès électroniques, sans oublier tous les documents de sécurité tels que par exemple un moyen de paiement, tel qu'un billet de banque, un chèque ou un ticket restaurant, un document d'identité, tel qu'une carte d'identité, un visa, un passeport ou un permis de conduire, un ticket de loterie, un titre de transport ou encore un ticket d'entrée à des manifestations culturelles ou sportives.

Il existe principalement deux types d'étiquettes RFID, les étiquettes comprenant un circuit électronique intégré, dites étiquettes à puce (électronique), et les étiquettes ne comprenant pas de circuit électronique intégré, généralement désignées dans la technique par les termes anglais « chip-less RFID tags » - étiquettes RFID sans puce.

Les étiquettes RFID à puce (actives ou passives) comprennent généralement une antenne, un circuit électronique, une mémoire pour stocker un code d'identification. Le circuit électronique permet notamment de recevoir le signal émis par la borne de lecture et d'émettre en réponse, dans une bande de fréquences déterminée, un signal modulé contenant le code d'identification stocké dans la mémoire. Pour les étiquettes RFID à puce passives, une partie de l'énergie portée par les ondes radio émises par la borne de lecture sert à alimenter électriquement la puce.

Du fait de la présence de circuits électroniques dans les étiquettes RFID à puce, ces étiquettes ont un coût de revient non négligeable. C'est notamment pour réduire ce coût de revient qu'on a proposé de réaliser des étiquettes sans puce. Ce type d'étiquette RFID sans puce ne nécessite donc ni circuit intégré, ni composants électroniques discrets, tels que par exemple un transistor et/ou une bobine et/ou une capacité et/ou une antenne; c'est leur caractéristique géométrique conductrice qui engendre un comportement spécifique, notamment de type résonateur. Cette caractéristique de résonance à fréquence donnée permet d'imprimer des étiquettes RFID sans puce directement sur un objet à des coûts inférieurs à ceux des étiquettes RFID traditionnelles.

L'augmentation de la capacité de codage des dispositifs d'identification par fréquence radio sans puce ainsi que la fabrication de ces dispositifs et, en particulier, la fabrication industrielle de dispositifs discriminants constituent des challenges importants de l'état de la technique.

Dans « Technologies des microsystèmes » (volume 24, pages 4373 - 4382 (2018)), Zhong-Hua Ma, Jian-Hong Yang, Chih-Cheng Chen et Cheng-Fu Yang proposent une étiquette sans puce retransmise basée sur une structure CSRR à Q élevé fonctionnant sur la bande de fréquences UWB est proposée, qui est composée de deux antennes monopôles à large bande à microruban émettant et recevant une polarisation orthogonale, chargées de plusieurs résonateurs CSRR. Dans la partie expérimentale de cet article, aux chapitres 6 et 7, c'est avant tout un substrat diélectrique de type Rogers 4350 qui est utilisé (avec une constante diélectrique relative de 3,66, une tangente de perte de 0,004 et une épaisseur de 0,508 mm - plusieurs épaisseurs étant également testées (0,3, 0,508 et 0,8 mm, respectivement) ; ce substrat diélectrique est ensuite remplacé respectivement par un substrat en plastique (avec une constante diélectrique relative de 3,1, une tangente de perte de 0,008 et une épaisseur de 1 mm) ainsi que par de la mousse (constante diélectrique relative de 1,06 , tangente de perte de 0,0015 et épaisseur de 1 mm, la seule conclusion triée de ces changements étant que « le spectre de sortie indique correctement l'état du codage » sans autre indication.

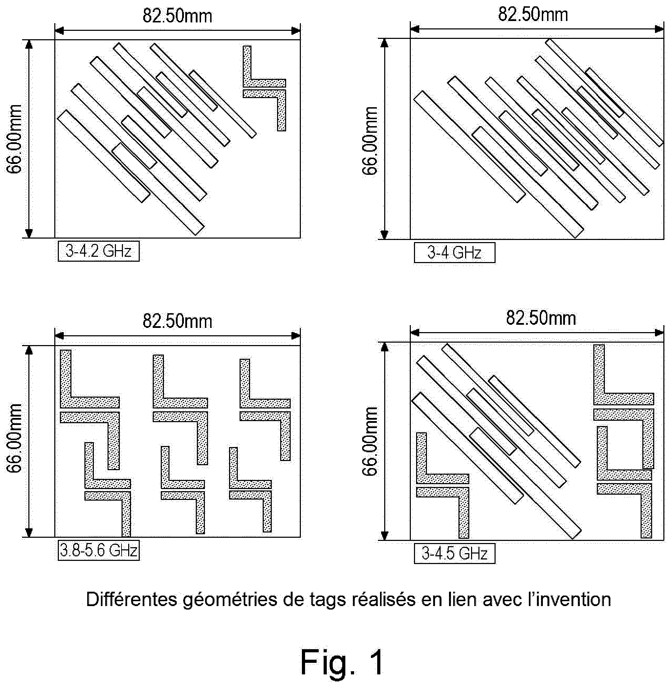

Dans la publication "2013 IEEE Antennas and Propagation Society International Symposium (APSURSI), Conference: 7-13 July 2013, IEEE Xplore: 27 January 2014, INSPEC Accession Number: 14058155, DOI: 10.1109/APS.2013.6711573, pages1828-1829", Peixeiro Custodio présente des éléments d'antenne patch microruban à haut rendement développés dans le cadre d'un projet de recherche de l'Union européenne sur la technologie « radio verte ». La figure 1 représente une configuration de patchs empilés couplés à une ouverture large bande avec des substrats constitués de 3 couches de Rogers Duroid 5880 et d'une couche en mousse de 10 mm d'épaisseur. Ces antennes n'ont pas la même fonction/utilité que les étiquettes sans puce de la présente invention - les problématiques de conception sont donc différentes.

Dans [IEEE Access ( Volume: 7) / Page(s): 138707 - 138720 / Date de Publication: 14 August 2019 / Electronic ISSN: 2169-3536 / INSPEC Accession Number: 19088375 / DOI: 10.1109/ACCESS.2019.2935258] Svanda Milan et Al. décrivent des « Étiquettes RFID sans puce à plaque dipolaire à haute capacité de codage ». Dans le dernier paragraphe de la section III relatif à la topologie d'Étiquette RFID sans puce de 20-Bit, il est indiqué que le substrat est constitué de Rogers RO4350 (constante diélectrique relative de 3,66 , tangente de perte de 0,003 et épaisseur de 0,1 mm) et d'une couche de mousse (constante diélectrique relative de 1,3 , tangente de perte de 0,02 et épaisseur de 1 mm).

Dans la publication [2019 IEEE International Conference on RFID Technology and Applications (RFID-TA) - Date of Conference: 25-27 Sept. 2019 - INSPEC Accession Number: 19135523 - pages 174-177], Laura Corchia et Al. decrivent des « A Chipless Humidity Sensor for Wearable Applications », soit des capteurs d'humidité pour les habits.

Dans un article intitulé publié dans IEEE Transactions on Microwave Theory and Techniques (Pages: 4547 - 4558 du Volume: 67, Issue: 11, Nov. 2019 - "Scalar Method for Reading of Chipless RFID Tags Based on Limited Ground Plane Backed Dipole Resonator Array"), Jan Kracek decrit une méthode scalaire pour la lecture d'étiquettes RFID sans puce. Cette publication décrit à la figure 9(a) une étiquette RFID sans puce constituée d'un réseau de résonateurs dipôles avec plan de masse et comprenant comme couches intermédiaires un substrat RO4350 (diélectrique de type Rogers) de 0,1 mm d'épaisseur, de permittivité relative 3,66 et de tangente d'angle de perte 0,003, ainsi qu'une couche de mousse d'épaisseur de 1 mm insérée entre le plan de masse et le substrat, de permittivité relative 1,3 et de tangente d'angle de perte 0,02.

EP3537855 (A1) concerne un dispositif d'identification par fréquence radio (« RFID ») sans puce et la fabrication d'étiquettes RFID sans puce.

Bien que la technologie RFID sans puce soit promise à un bel avenir, il n'en demeure pas moins que l'on recherche toujours à améliorer les performances de lecture des tags RFID sans puce. Par performance de lecture on entend la capacite du tag à être lu et identifié soit, par exemple, l'augmentation du niveau signal du tag (signal utile porteur de l'information du tag) par rapports aux autres signaux comme le bruit de mesure ou encore les signaux rétrodiffusés par d'autres objets proches du tag. Un travail spécifique sur le tag lui-même et notamment les matériaux le composant est essentiel pour répondre à la problématique des performances de lecture ainsi que de fabrication et de coût de ces étiquettes. Les matériaux utilisés pour la constitution des tags vont avoir un impact direct sur le signal utile rétrodiffusé par le tag.

### Invention

Ainsi, la présente invention apporte une solution prometteuse à cette problématique en proposant des nouveaux dispositifs d'identification par fréquence radio (« RFID ») sans puce (personnalisés), en particulier des étiquettes RFID sans puce (personnalisées), aussi appelées « chip-less RFID tags ».

L'invention est définie dans la revendication indépendante 1. Des réalisations particulières sont définies dans les revendications dépendantes 2-23.

En particulier, la présente invention concerne des dispositifs d'identification par fréquence radio sans puce, de préférence des étiquettes RFID sans puce, caractérisés en ce qu'ils comprennent un substrat diélectrique particulier surmonté de motif(s) constitué(s) d'une couche de matière conductrice ; de préférence un substrat diélectrique en mousse solide, en carton mousse, en carton ondulé, en carton alvéolaire ou en tissu (par exemple en un matériau constitué de fils ou de fibres entrelacés en coton, chanvre, lin ou synthétiques tels le nylon, le polyamide ou la viscose), surmonté de motif(s) constitué(s) d'une couche de matière conductrice.

Comme décrit plus en détail dans la description qui suit, on entend de préférence par mousse solide un matériau diélectrique pouvant être rigide, ou flexible, qui contient un pourcentage important de boules d'air ou de gaz et qui donc, tout en occupant un certain volume, ne contient que très peu de matière à l'état solide, l'état solide étant de préférence un état de la matière caractérisé par l'absence de liberté entre les molécules ou les ions ; ainsi, une mousse est généralement caractérisée par une permittivité relative très faible, à savoir proche de 1, 1 étant la valeur de la permittivité de l'air.

En effet, la demanderesse a constaté de manière inattendue que cet ensemble substrat diélectrique et motif conducteur conforme à la présente invention permettait d'obtenir des dispositifs qui présentaient non seulement des caractéristiques de résonance optimales tout en présentant une efficacité de rayonnement supérieure et également une performance de lecture supérieure ; ainsi, c'est bien au moins la somme des deux couches, diélectrique et motif conducteur, qui définissent les caractéristiques de résonance du dispositif selon l'invention. Cette découverte ouvre un vaste champ de nouvelles applications pour le domaine des étiquettes RFID sans puce car, comme démontré dans la présente demande, il est possible d'identifier facilement les dispositifs correspondant (leur signature RF restant reconnaissable) tout en facilitant leur fabrication. Ceci est d'autant plus inattendu et contre-intuitif car il était connu dans la technique que la préservation des propriétés conductrices de surface du tag constituait une exigence de fabrication afin que le tag conserve une signature radiofréquence exploitable ; ceci est encore plus inattendu et contre-intuitif car il était connu dans la technique que la présence d'un substrat avec une forte permittivité permet d'améliorer la capacité du tag de résonner (augmentation du facteur de qualité des résonateurs du tag). En effet, plus la permittivité du substrat est importante, plus le champ est stocké au niveau du diélectrique présent à proximité des couches conductrices et meilleure est la résonnance (augmentation du facteur de qualité). Or, un facteur de qualité important est connu pour être un critère fondamental dans la capacité du lecteur à pouvoir lire le tag dans un environnement réel, à savoir comportant des objets autre que l'étiquette RFID. Plus le facteur de qualité est important, plus il sera possible de séparer temporellement le signal émis par le tag du signal environnement ce qui permet de réaliser une mesure correcte du tag et c'est donc la configuration recherchée en pratique.

Dans le cadre de la présente invention, l'utilisation du qualificatif « personnalisé » pour les dispositifs/étiquettes revendiqués vient simplement confirmer que l'identification/discrimination du dispositif / de l'étiquette est possible.

### Substrat diélectrique

Les dispositifs/étiquettes RFID sans puce selon la présente invention sont donc caractérisés en ce qu'ils comprennent un substrat diélectrique particulier.

Ce substrat diélectrique particulier sera avantageusement sélectionné parmi les substrats diélectriques répondant à au moins une des conditions suivantes :
- une masse volumique apparente inférieure à 250 kg.m⁻³ ; par exemple inférieure à 100 kg.m⁻³ ; et/ou
- une permittivité relative inférieure à 3 ; de préférence inférieure à 2 ; de préférence inférieure à 1,25. Par exemple, cette permittivité relative sera inférieure à 1,10. Dans un mode d'exécution particulier selon la présente invention, cette permittivité relative sera proche de 1. Cette permittivité relative sera de préférence supérieure à 1,001. Par exemple, cette permittivité relative sera supérieure à 1,01 ; et/ou
- une valeur de tangente d'angle de perte inférieure à 10⁻², de préférence inférieure à 10⁻³, par exemple inférieure à 2.10⁻⁴.

Ce substrat diélectrique particulier sera avantageusement sélectionné parmi les substrats diélectriques en mousse solide, en carton mousse, en carton ondulé, en carton alvéolaire ou en tissu (par exemple en un matériau constitué de fils ou de fibres entrelacés en coton, chanvre, lin ou synthétiques tels le nylon, le polyamide ou la viscose).

Ce substrat diélectrique sera avantageusement rigide ou flexible ; il se présentera de préférence sous la forme d'un film.

L'épaisseur du substrat diélectrique sera avantageusement supérieure à 0,1 mm. Cette épaisseur sera de préférence supérieure à 0,5 mm. Cette épaisseur sera par exemple supérieure à 0,75 mm.

L'épaisseur du substrat diélectrique sera avantageusement inférieure à 3 mm. Cette épaisseur sera de préférence inférieure à 1,5 mm. Cette épaisseur sera par exemple inférieure à 1,25 mm.

Tout substrat diélectrique répondant aux objectifs de performances de lecture et de résonance et de discrimination selon la présente invention pourra avantageusement être utilisée dans le cadre de la présente invention. On citera à titre illustratif le tissu (par exemple en un matériau constitué de fils ou de fibres entrelacés en coton, chanvre, lin ou synthétiques tels le nylon, le polyamide ou la viscose), le carton ondulé, le carton alvéolaire, le carton mousse, la mousse solide, par exemple les polymères ou biopolymères.

Dans un mode d'exécution particulier selon la présente invention, le substrat diélectrique est caractérisé par sa masse volumique apparente qui est inférieure à 250 kg.m⁻³ ; par exemple inférieure à 100 kg.m⁻³. La masse volumique apparente peut être mesurée par toute méthode appropriée, par exemple par pesage. Sauf indications contraires, les masses volumiques sont données pour des corps à la température de 20 °C, sous la pression atmosphérique normale (1 013 hPa). On pourra aussi avantageusement utiliser toute méthode ASTM ou ISO applicable au type de matériau sélectionné comme substrat diélectrique pour la mesure de cette masse volumique apparente ; quelle que soit la méthode ASTM ou ISO choisie (et applicable au type de matériau sélectionné), la mesure de la masse volumique apparente sera donc de préférence inférieure à 250 kg.m⁻³ ; par exemple inférieure à 100 kg.m⁻³.

Dans un mode d'exécution particulier selon la présente invention, le substrat diélectrique est caractérisé par ses propriétés diélectriques, à savoir une permittivité relative inférieure à 3, de préférence inférieure à 2. Cette permittivité relative sera de préférence inférieure à 1,25. Par exemple, cette permittivité relative sera inférieure à 1,10. Dans un mode d'exécution particulier selon la présente invention, cette permittivité relative sera proche de 1. Cette permittivité relative sera de préférence supérieure à 1,001. Par exemple, cette permittivité relative sera supérieure à 1,01.

Dans un mode d'exécution particulier selon la présente invention, le substrat diélectrique est caractérisé par ses propriétés diélectriques, à savoir une valeur de tangente d'angle de perte inférieure à 10⁻², de préférence inférieure à 10⁻³, par exemple inférieure à 2.10⁻⁴.

Pour rappel, la permittivité diélectrique est une propriété physique qui décrit la réponse d'un matériau lorsqu'on lui applique un champ électrique ; et la tangente de l'angle de perte est également appelé facteur de dissipation diélectrique.

Les permittivité relative et tangente d'angle de perte (« tan δ ») peuvent être mesurés par toute méthode appropriée. Nous citerons à titre illustratif l'utilisation de la spectroscopie diélectrique ou de cavités résonnantes qui sont des techniques d'analyse diélectrique généralement utilisées. Ces techniques sont basées sur la mesure de l'impédance complexe d'un échantillon à une fréquence donnée voire à une température elle aussi donnée. La présente invention concerne des applications pour des températures autour de la température ambiante (typiquement entre -20°C et +80°C), dans cette plage de température, la permittivité ainsi que les pertes diélectriques des matériaux diélectriques communément présents autour de nous peuvent être considérées comme relativement constantes notamment dans la bande d'intérêt qui est la bande ULB entre 3GHz et 10 GHz.

Cette méthode permet d'avoir accès à la valeur de la permittivité d'un matériau ou encore à son facteur de perte tan δ à une fréquence donnée par exemple. Les valeurs indiquées dans la présente description et les revendications qui suivent correspondent à celles mesurées à toute fréquence comprise dans la bande de fréquences de 3 GHz à 10 GHz, à une température de 20°C.

En particulier, les valeurs indiquées dans les exemples qui suivent ont été mesurées au moyen du modèle 08 de Damaskos (« Thin Sheet Tester - Cavity ») qui permet d'obtenir une excellente estimation de la permittivité diélectrique des substrats diélectriques; ce testeur de feuille mince Damaskos donne également la mesure de la tangente de perte du diélectrique sur la bande de 800-4000 MHz de manière non destructive ce qui convient particulièrement bien à nos substrats. La mesure est réalisée sur des analyseurs vectoriels et scalaires communs sous contrôle de l'équipement Damaskos et le traitement des données du logiciel « Cavity » vendu par la société Damaskos ce qui offre une très bonne répétabilité.

### Mousse solide

La mousse solide (par exemple la mousse en polymère), est une mousse solide utilisée à titre illustratif dans de nombreuses applications telles que l'isolation thermique, l'isolation acoustique, les emballages, l'automobile, etc. Cette mousse peut être assimilée à un réseau continu solide comprenant des bulles de gaz (en général d'air) piégées ce qui permet de combiner les propriétés d'une mousse (densité, légèreté) avec celle d'un solide.

La mousse solide peut avantageusement être caractérisée par sa nature, sa densité, sa structure à cellules fermées ou ouvertes, la taille de ses bulles et l'arrangement desdites bulles dans l'espace.

Une mousse solide est dite de faible densité quand elle contient plus de 90% de gaz, ce qui correspond à une masse volumique apparente inférieure à 100 kg.m⁻³. Une mousse de densité moyenne a une masse volumique apparente comprise entre 100 et 600 kg.m⁻³. Enfin, une mousse solide de densité élevée contient moins de 60% de gaz, ce qui correspond à une masse volumique apparente supérieure à 600 kg.m⁻³. La masse volumique apparente peut être mesurée par toute méthode appropriée, par exemple par pesage. Sauf indications contraires, les masses volumiques sont données pour des corps à la température de 20 °C, sous la pression atmosphérique normale (1 013 hPa).

La mousse solide utilisée dans le cadre de la présente invention aura de préférence une masse volumique apparente inférieure à 250 kg.m⁻³. Elle aura par exemple une masse volumique apparente inférieure à 100 kg.m⁻³.

La mousse solide utilisée dans le cadre de la présente invention aura de préférence une densité de bulles comprise entre 10⁴ et 10⁹ bulles/cm³. Elle aura par exemple une densité de bulles comprise 10⁵ et 10⁸ bulles/cm³.

La mousse solide utilisée dans le cadre de la présente invention aura de préférence une taille des bulles dont le diamètre moyen est compris entre 5 microns et 1 millimètre. Elle aura par exemple un diamètre moyen compris entre 20 microns et 200 microns.

Toute matière présentant les caractéristiques de mousse revendiquées dans le cadre de la présente invention pourra avantageusement être sélectionnée. Nous citerons à titre illustratif le carton mousse, les polymères ou biopolymères. Par polymère on comprend en général un ensemble constitué de plusieurs macromolécules (molécule constituée de la répétition de nombreuses sous-unités) ; en générale, lorsque la masse molaire du matériau est supérieure à 2 000 g/mole on parle de polymère.

Dans un mode d'exécution particulier selon la présente invention, la mousse solide sera une mousse en polymère, par exemple un polymère sélectionné parmi les thermodurcissables tels que les polyuréthanes, époxydes,... ou, de préférence, parmi les thermoplastiques tels que les polystyrène, chlorure de polyvinyle, polypropylène, polyéthylène, polyéthylène téréphtalate (PET) et/ou un mélange d'un ou plusieurs de ces polymères cités. Une mousse comprenant plus de 80% en poids, par exemple plus de 90% en poids, de polyéthylène (PE) ou de polyéthylène téréphtalate (PET) sera avantageusement sélectionnée dans le cadre de la présente invention.

La morphologie des mousses, en particulier la taille des bulles et la densité de bulles, pourra être déterminée par toute méthode appropriée. A titre illustratif, la mousse (par exemple la mousse de polymère) est fracturée sous azote liquide afin de se positionner en-dessous de la température de transition vitreuse du polymère ; comme la surface de fracture est nette, les bulles ne sont pas déformées et peuvent être observées par exemple par microscopie. On utilisera de préférence un microscope électronique couplé à un logiciel d'analyse d'image capable de compter le nombre de bulles ; et aussi de calculer l'aire moyenne des bulles pour chaque image, ce qui permet de déterminer le diamètre moyen des bulles, et le diamètre moyen équivalent lorsque les bulles ne sont pas sphériques - la densité de bulles (le nombre de bulles par cm³) est déterminée par la formule (n/A)^{(3/2)} avec n étant le nombre de bulles dans l'image et A l'aire de l'image.

La mousse de polymère peut être préparée par toute méthode appropriée. Nous citerons à titre illustratif le moussage physique avec injection de gaz (par exemple du CO₂ ou du diazote (N₂)) ou le moussage chimique avec ajout et décomposition d'un agent gonflant (par exemple le 5-Phenyltetrazole, le p-Toluene sulfonyl semicarbazide, le Dinitrospoenta-methylenetetramine, le p-Toluene sulfonyl hydrazide, le p.p-Oxybis(benzene)sulfonyl hydrazide et/ou l'Azodicabonamide qui est préférentiellement utilisé).

Un procédé d'extrusion soufflage est particulièrement adapté à la préparation d'un film de mousse de polymère pouvant être utilisé dans le cadre de la présente invention.

Des agents de nucléation peuvent avantageusement être ajoutés au polymère ce qui permet d'obtenir des bulles de petites tailles. On citera à titre illustratif des charges inorganiques (par exemple les acides stéariques, le stéarate de calcium, le stéarate de zinc, le carbonate de calcium, le silicate de magnésium, le talc, le benzoate de sodium, des phases organiques telles que des élastomères et/ou des particules de caoutchouc, du noir de carbone, et/ou des nanoparticules telles que par exemple des nano argiles ou des nanoparticules de carbone (par exemple des nanotubes).

Dans un mode d'exécution particulier selon la présente invention, la mousse solide sera sélectionnée parmi les cartons mousse, également appelés cartons plume ; ce type de matériau se compose en général de trois couches dont une couche interne principale de mousse de polymère (par exemple du polystyrène, du polyuréthane, du polyéthylène et/ou du polyéthylène téréphtalate (PET)) revêtue à l'extérieur d'une fine pellicule, par exemple du papier ou du plastique. Le type de papier ou de plastique représentant la couche supérieure optionnelle du substrat diélectrique surmonté de motif(s) constitué(s) d'une couche de matière conductrice n'est pas critique car elle représente une épaisseur infime par rapport à celle de la mousse solide comme expliqué en détail ci-dessous.

De manière générale, et dans un mode d'exécution particulier selon la présente invention, le substrat diélectrique (par exemple la mousse solide, le carton mousse, le carton ondulé, le carton alvéolaire et/ou le tissu, de préférence la mousse solide) avec ses caractéristiques telles qu'ici décrites et/ou revendiquées représente au moins 95% en volume et/ou 95% en épaisseur et/ou 95% en poids de l'entièreté du substrat diélectrique sur lequel est(sont) apposé(s) le(s) motif(s) constitué(s) d'une couche de matière conductrice, de préférence au moins 99% en volume et/ou 99% en épaisseur et/ou 99% en poids de l'entièreté du substrat diélectrique sur lequel est(sont) apposé(s) les motif(s) constitué(s) d'une couche de matière conductrice. La présente invention concerne donc également une étiquette RFID sans puce consistant en un substrat diélectrique qui est lui-même constitué d'un substrat diélectrique avec ses caractéristiques telles qu'ici décrites et/ou revendiquées surmonté d'une fine couche diélectrique sur laquelle est(sont) apposé(s) le(s) motif(s) constitué(s) d'une couche de matière conductrice ; cette fine couche diélectrique (par exemple une pellicule de papier ou de carton ou de matière plastique (par exemple : une pellicule de polyéthylène (PE), de polypropylène (PP) ou de préférence de polyéthylène téréphtalate (PET)) représente donc avantageusement moins de 5%, voire moins de 1% de l'épaisseur de l'entièreté du substrat diélectrique.

Bien qu'à priori optionnelle et non critique, la Demanderesse a constaté que cette fine couche diélectrique ou pellicule diélectrique apportait de nombreux avantages additionnels à l'étiquette RFID revendiquée moyennant quelques exigences préférées.

Tout d'abord, il est important de mentionner que les valeurs de permittivité relative et de tangente d'angle de perte « relatives » de l'empilement diélectrique correspondant de l'étiquette revendiquée auront toujours des valeurs répondant aux valeurs caractéristiques revendiquées ; l'influence de la pellicule diélectrique additionnelle sur l'ensemble diélectrique sera donc insignifiante par rapport à ces critères.

Ensuite, et ceci représente un avantage considérable d'un mode de réalisation selon la présente invention, la Demanderesse a constaté que la planéité et/ou l'état de surface de la surface diélectrique sur laquelle était apposé le motif conducteur pouvaient aussi représenter une problématique additionnelle dans la réalisation de l'étiquette ; en effet, comme il arrive fréquemment que la couche supérieure du diélectrique principal (par exemple la mousse solide, le carton mousse, le carton ondulé, le carton alvéolaire et/ou le tissu, de préférence la mousse solide) de l'étiquette ne présente pas une bonne planéité et/ou un bon état de surface, l'utilisation d'une pellicule diélectrique additionnelle a permis d'obtenir de meilleurs résultats/performances car, entre autres, elle apportait cette planéité et/ou état de surface recherchés. Ainsi, en apposant les motif(s) constitué(s) d'une couche de matière conductrice directement sur cette pellicule diélectrique, de meilleures performances ont pu être obtenues. Toute méthode appropriée pourra être utilisée pour caractériser cette planéité et/ou état de surface de la pellicule conductrice. A titre illustratif, et afin d'éviter de devoir entrer dans des considérations de mesures difficiles à mettre en œuvre, les étiquettes revendiquées seront avantageusement caractérisées par une épaisseur totale en tout point de l'étiquette qui varie de moins de cent (100) microns, de préférence de moins de cinquante (50) microns, par exemple de moins de quarante (40) microns, de moins de vingt (20) microns, de moins de dix (10) microns, voire par exemple de moins de deux (2) microns. L'apposition des motif(s) constitué(s) d'une couche de matière conductrice directement sur cette pellicule diélectrique pourra être effectuée par toute méthode appropriée comme expliqué ci-après dans la description, par exemple par impression, par exemple par impression jet d'encre. Ensuite, la pellicule diélectrique recouverte des motif(s) constitué(s) d'une couche de matière conductrice pourra être ajoutée au substrat diélectrique principal (la mousse solide, le carton mousse, le carton ondulé, le carton alvéolaire et/ou le tissu, de préférence la mousse solide) dans n'importe quel sens/ordre ; la Demanderesse a même trouvé un avantage à effectuer l'empilement successif (1) substrat diélectrique principal - (2) motif conducteur - (3) pellicule diélectrique - car cet empilement permettait de protéger avantageusement les motifs conducteurs lors de la manipulation et/ou utilisation de l'étiquette puisque ces motifs étaient protégés à la fois d'un côté par le substrat diélectrique principal et de l'autre côté par la pellicule diélectrique.

Dans un mode d'exécution particulier, la pellicule diélectrique est caractérisée par l'une, deux ou plusieurs des caractéristiques suivantes :
- une permittivité relative mesurée à toute fréquence comprise entre 3 et 10 GHz supérieure à celle du substrat diélectrique principal (la mousse solide, le carton mousse, le carton ondulé, le carton alvéolaire et/ou le tissu, de préférence la mousse solide) ; de préférence une permittivité relative supérieure à 1,25 , par exemple supérieure à 2 ; de préférence une permittivité relative inférieure à 3,5 ; et/ou
- une valeur de tangente d'angle de perte mesurée à toute fréquence comprise entre 3 et 10 GHz supérieure à celle du substrat diélectrique principal (la mousse solide, le carton mousse, le carton ondulé, le carton alvéolaire et/ou le tissu, de préférence la mousse solide) ; de préférence une valeur de tangente d'angle de perte inférieure à 2.10⁻² ; et/ou
- une épaisseur au moins dix fois inférieure à celle du substrat diélectrique principal (la mousse solide, le carton mousse, le carton ondulé, le carton alvéolaire et/ou le tissu, de préférence la mousse solide) ; de préférence une épaisseur inférieure à 100 microns, par exemple inférieure à 50 microns ; et/ou
- constituée de matière plastique, par exemple de polyéthylène, de polypropylène ou de polyéthylène téréphtalate.

Dans un mode d'exécution particulier, la constitution chimique principale de la pellicule diélectrique est identique à celle du substrat diélectrique principal. A titre illustratif, si le substrat diélectrique principal est une mousse de polyéthylène téréphtalate, la pellicule diélectrique additionnelle sera aussi à base de polyéthylène téréphtalate.

### Carton

Comme indiqué précédemment le substrat diélectrique selon la présente invention pourra à titre illustratif être sélectionné parmi le carton ondulé ou le carton alvéolaire. A titre illustratif, le carton ondulé sera sélectionné parmi les cartons à cannelure B (appelée également PC, en général d'épaisseur comprise entre 2,5 et 3,5 mm), les cartons à cannelure E (appelée également micro-cannelure, en général d'épaisseur comprise entre 2 et 1,5 mm) ; les cartons à cannelure F (appelée également Minimicro, en général d'épaisseur d'environ 1,2 mm), les cartons à cannelure G ou N (dite Nano-cannelure) d'épaisseur d'environ 0,8 mm, les cartons à cannelure O, d'épaisseur d'environ 0,5 mm, ou d'un mélange de deux ou plusieurs des cartons pré-cités.

Le carton utilisé dans le cadre de la présente invention aura de préférence une masse volumique apparente inférieure à 250 kg.m⁻³. Il aura par exemple une masse volumique apparente inférieure à 100 kg.m⁻³.

Dans un mode de réalisation particulier selon la présente invention, l'étiquette RFID sans puce consistant en un substrat diélectrique surmonté de motif(s) constitué(s) d'une couche de matière conductrice est caractérisée en ce que la partie supérieure du substrat diélectrique est en contact avec le(s) motif(s) constitué(s) d'une couche de matière conductrice. En effet, en plus des avantages liés à la surface plane/lisse de la partie supérieure du substrat diélectrique mentionnés ci-dessus, la Demanderesse a également découvert qu'il était préférable d'éviter la présence de tout autre matière entre ces deux couches (substrat/pellicule optionnelle/motifs conducteurs) ; à titre illustratif, aucune colle n'est utilisée entre ces deux parties de l'étiquette.

### Couche conductrice

Les dispositifs d'identification par fréquence radio sans puce, de préférence des étiquettes RFID sans puce, selon la présente invention sont donc caractérisés en ce qu'ils comprennent un substrat diélectrique particulier surmonté de motif(s) constitué(s) d'une couche de matière conductrice. Dans un cas particulier propre à la présente invention, les dispositifs d'identification par fréquence radio sans puce, de préférence les étiquettes RFID sans puce, comprennent également sous le substrat diélectrique une ou plusieurs couches de matière conductrice ; de préférence sous toute la surface du substrat diélectrique. La configuration comportant deux couches conductrices, une sous le substrat diélectrique et le(s) motif(s) au-dessus du substrat diélectrique, est un cas particulièrement intéressant pour l'invention (substrat diélectrique en sandwich entre les deux couches conductrices) comme expliqué ci-dessous dans la description des tags avec plan de masse.

Dans un mode d'exécution particulier selon la présente invention, la matière de la couche conductrice constituant le motif comprend (ou de préférence consiste en) un matériau choisi dans le groupe consistant en du graphite, du cuivre, du nickel, de l'argent, de l'aluminium, du platine et/ou leurs mélanges, de préférence du cuivre et/ou de l'argent et/ou de l'aluminium.

Dans un mode d'exécution particulier selon la présente invention, la couche conductrice constituant le motif est caractérisée par une épaisseur de matière conductrice supérieure à 100 nm. On utilisera par exemple une épaisseur de plus de 150 nm. On utilisera par exemple une épaisseur de plus de 200 nm. On utilisera par exemple une épaisseur de plus de 250 nm. On utilisera par exemple une épaisseur de plus de 300 nm. On utilisera par exemple une épaisseur de plus de 400 nm. On utilisera par exemple une épaisseur de plus de 500 nm.

Dans un mode d'exécution particulier selon la présente invention, la couche conductrice constituant le motif est caractérisée par une épaisseur de matière conductrice inférieure à 20 microns. L'épaisseur de matière conductrice sera de préférence inférieure à 10 microns, voire inférieure à 2 microns. On utilisera par exemple une épaisseur de moins de 1,5 microns. On utilisera par exemple une épaisseur de moins de 1 micron.

La couche de matière conductrice peut être déposée, de préférence directement sur le substrat diélectrique ou sur la pellicule diélectrique optionnelle, par toute méthode de dépôt appropriée.

Selon la présente invention et dans un mode d'exécution de fabrication particulier, le substrat diélectrique se présente généralement sous une forme de film de dimension rectangulaire ou carrée, par exemple une feuille épaisse ou une fine pellicule dans le mode optionnel utilisant une pellicule diélectrique. Cette feuille (ou pellicule) se déplace, en général grâce à un système de transport de substrats dans une machine d'impression, le long d'un chemin de transport orienté selon un axe longitudinal depuis au moins un magasin d'entrée fournissant les dits substrats imprimables et/ou personnalisables, jusqu'à au moins un magasin de sortie recevant les substrats imprimés et/ou personnalisés, et donc recouverts des motifs de matière conductrice conformément à la présente invention. Les « bords latéraux » du substrat sont les deux bords situés de part et d'autre de cet axe longitudinal; les bords avant et/ou arrière sont ses bords transversaux. Le substrat peut également se présenter sous la forme de bobine dans une machine de type bobine-bobine.

Nous citerons à titre illustratif comme méthode appropriée pour la fabrication du dispositif/tag revendiqué une méthode d'impression d'encre conductrice, en particulier une méthode d'impression numérique d'encre conductrice, plus particulièrement une méthode d'impression numérique d'encre conductrice par jet d'encre à la demande. Cette impression d'encre conductrice par jet d'encre à la demande utilise de préférence des têtes d'impression piézoélectriques.

Nous citerons également à titre illustratif comme méthode alternative appropriée pour la méthode de dépôt d'un motif constitué d'une couche de matière conductrice une méthode qui comprend une étape d'impression numérique d'un premier motif constitué d'un produit d'impression, de préférence diélectrique, tel qu'une encre, un vernis et/ou un toner, suivie d'une étape de dépôt par superposition au premier motif imprimé d'un motif identique constitué d'un film conducteur comprenant une pellicule d'application en contact avec le produit d'impression et une pellicule conductrice. Nous citerons à titre illustratif comme méthode appropriée pour l'étape d'impression du premier motif toute méthode d'impression numérique, plus particulièrement une méthode d'impression numérique par jet à la demande. Cette impression par jet à la demande utilise de préférence des têtes d'impression piézoélectriques. A titre illustratif, l'étape d'application du film sur le premier motif s'effectue dans des conditions de pression et de température entrainant la co-adhésion sélective entre le produit d'impression et la pellicule d'application du film par exemple au moyen d'un ou plusieurs ensembles de rouleaux de pincement et/ou d'un ou plusieurs rouleaux de pression.

Nous citerons également à titre illustratif comme méthode alternative appropriée pour la méthode de dépôt d'un motif constitué d'une couche de matière conductrice une méthode par transfert thermique de la matière conductrice.

Nous citerons également à titre illustratif comme méthode alternative appropriée pour la réalisation du tag la méthode d'assemblage successif de pellicules entre elles comprenant la réalisation d'une pellicule conductrice (par exemple : une couche aluminium découpée d'une épaisseur illustrative de 5 à 20µm) qui peut être déposée sur une pellicule optionnelle de transport (par exemple : un PET) avant ou après découpage suivie par une couche de mousse puis une pellicule conductrice (par exemple une couche d'aluminium). Le maintien des pellicules/couches entre elles pourra être fait par une colle adaptée ; toutefois, une méthode d'enveloppement ou de soudure telle que décrite ci-dessous sera préférée car elle permet de s'affranchir de la présence de colle. D'un point de vue schématique illustratif, cela correspond à une réalisation de tag qui se caractérise par la production de 2 couches "complexes" et d'une étape de découpe ; par exemple, on réalise une couche "complexe" métal (représentée dans les illustrations ci-dessous par l'exemple de l'aluminium) ALU/PET avec de la colle:
-------- ALU -------- avec une épaisseur illustrative de 5 à 20 µm
------- Colle --------
-------- PET --------

Puis cette couche sera découpée pour réaliser les tags. Ensuite, il faut réaliser la dernière couche "complexe" métal (représentée dans les illustrations ci-dessous par l'exemple de l'aluminium) MOUSSE/ALU :
---- MOUSSE ----
-------- ALU --------

Enfin il faut assembler ces 2 couches complexes pour former les tags :
-------- ALU -------- avec une épaisseur illustrative de 5 à 20 µm
------- Colle --------
-------- PET --------
---- MOUSSE ----
-------- ALU --------

Nous citerons également à titre illustratif comme méthode alternative appropriée pour la réalisation du tag une production de 2 couches "complexes" et d'une étape de réaction chimique. Tout d'abord, il faut réaliser une couche "complexe" métal (représentée dans les illustrations ci-dessous par l'exemple de l'aluminium) ALU/PET :
-------- ALU -------- avec une épaisseur de 5 à 20 µm (test à 12µm)
------- Colle -------- (optionnelle)
-------- PET --------

Puis un vernis protecteur est déposé de façon à former le dessin du tag sur la face aluminium (le vernis protège uniquement l'aluminium utile pour le tag).

Ensuite cette couche avec le vernis sera plongée dans un bain chimique qui enlèvera l'aluminium qui n'est pas protégé par le vernis. Après, il faut réaliser la dernière couche "complexe" métal (représentée dans les illustrations ci-dessous par l'exemple de l'aluminium) MOUSSE/ALU :
---- MOUSSE ----
-------- ALU --------

Enfin il faut assembler ces 2 couches complexes pour former le tag ; une illustration des couches correspondantes successives est indiquée ci-dessous :
----- VERNIS ------ représentant le tag
-------- ALU -------- représentant le tag avec une épaisseur de 5 à 20 µm
------- Colle -------- (optionnelle)
-------- PET --------
---- MOUSSE ----
-------- PET --------
------- Colle -------- (optionnelle)
-------- ALU --------

L'utilisation d'un scotch/aluminium est également envisageable pour la fabrication d'un tag. Il suffira de procéder à sa découpe pour réaliser les motifs conducteurs qui seront ensuite collés sur le substrat approprié sélectionné.

Nous citerons également à titre illustratif comme méthode alternative appropriée et préférée pour la réalisation du tag la méthode d'assemblage successif des couches de l'étiquette par enveloppement ou encore soudure aux extrémités des dites couches. Dans ce mode particulier, l'objectif est de s'affranchir de l'utilisation de colle entre les surfaces successives de contact des couches de l'étiquette RFID tout en assurant un contact intime entre lesdites surface ; tout moyen approprié à la réalisation de ce double objectif pourra être avantageusement utilisé. La technique d'enveloppement des couches avec maintien du contact entre les surfaces des dites couches a été expérimentée avec succès. Une technique de soudure aux extrémités des couches (proche des bords extérieurs de l'étiquette) a également pu être réalisée avec succès ; à titre illustratif, cette soudure peut avantageusement être réalisée au moyen d'un dispositif de type bobine-bobine au moyen duquel les couches empilées des étiquettes préalablement enroulées seront déroulées et ensuite soudées aux endroits appropriés pour capturer et assembler ainsi les étiquettes sans qu'il soit nécessaire de découper au préalable le substrat diélectrique principal (par exemple la mousse solide).

Ainsi, et ceci constitue un mode de réalisation préféré selon la présente invention, l'étiquette RFID sans puce sera constituée successivement de bas en haut
- d'une couche conductrice optionnelle mais préférée,
- surmontée d'une pellicule diélectrique optionnelle mais préférée,
- surmontée du substrat diélectrique principal (par exemple la mousse solide, le carton mousse, le carton ondulé, le carton alvéolaire et/ou le tissu, de préférence la mousse solide),
- surmontée d'une pellicule diélectrique sur laquelle est(sont) apposée(s) le(s) motif(s) constitué(s) d'une couche de matière conductrice, les dits motifs conducteurs pouvant se trouver soit sur la partie supérieure de l'étiquette, soit avantageusement entre le substrat diélectrique principal et la pellicule diélectrique.

La présente invention concerne donc un dispositif, de préférence un tag qui possède des caractéristiques de résonance. Dans un mode d'exécution particulier selon la présente invention, le tag revendiqué est constitué des substrats diélectriques revendiqués et des couches conductrices revendiquées.

### Tag

A titre illustratif, le tag RFID sans puce (personnalisé) selon la présente invention possède les caractéristiques suivantes :
∘ Un motif conducteur ou un ensemble de motifs conducteur caractérisant sa géométrie, avec de préférence au moins un ou plusieurs ou tous les motifs asymétriques,
∘ Un identifiant qui comprend au moins une fréquence de résonance *fr* et, de préférence, au moins un facteur de qualité Q,
∘ Résonant dans une bande de fréquences ultra large (ULB) caractérisée par une bande passante supérieure ou égale à 500 MHz, de préférence comprise entre 3,1 et 10,6 GHz,
∘ Avec ou sans plan de masse, et
∘Polarisant ou de préférence Dépolarisant.

### Tag - Géométrie

Grace aux possibilités de codage offertes par la méthode revendiquée, la Demanderesse a également développé toute une gamme de familles de tags nouvelle. Ainsi, dans un mode particulier, un tag sera de préférence composé d'au moins un motif, de préférence au moins deux motifs asymétriques. A titre d'exemple, la Figure 1 montre les tags avec plan de masse réalisés spécifiquement dans le cadre de la présente invention. Cette Figure 1 illustre quatre tags, chacun ayant six résonateurs. Deux familles de résonateurs (forme en double L - en gris foncé - et forme en double trait parallèle incliné à 45° - en gris clair) sont utilisées pour optimiser les performances du tag. La bande de fréquence dans laquelle se situent les fréquences de résonance de chacun des tags est indiquée en bas à gauche de chaque tag différentes géométries de tags réalisées en lien avec la méthode revendiquée.

### Tag - Identifiant

Le tag selon la présente invention sera de préférence caractérisé par un identifiant qui comprend au moins une fréquence de résonance *fr* et au moins un facteur de qualité Q.

### Tag Résonant

Le tag selon la présente invention est donc résonant dans une bande de fréquences ultra large (ULB) caractérisée par une bande passante supérieure ou égale à 500 MHz, de préférence comprise entre 3,1 et 10,6 GHz.

### Tag Passif

Comme déjà expliqué dans la partie introductive, notre type de dispositif d'identification par fréquence radio sans puce ne nécessite donc ni circuit intégré, ni composants électroniques discrets, tels que par exemple un transistor et/ou une bobine et/ou une capacité et/ou une antenne. Ce type de dispositif est donc caractérisé par un comportement passif car il ne devra pas intégrer de source d'énergie locale (telle qu'une batterie).

Pour rappel, par « dispositif » il faut comprendre un emballage, un document, une étiquette, notamment un document de sécurité ainsi qu'éventuellement tout objet et/ou être vivant sur lequel le marquage de l'identification par RFID sans puce peut être réalisé ou sur lequel un support du marquage peut être rapporté.

### Tag avec ou sans plan de masse

Le tag selon la présente invention peut être caractérisé en ce qu'il possède ou non un plan de masse. Dans sa plus simple expression, un tag avec plan de masse selon la présente invention se définit comme une structure comportant un substrat diélectrique plan d'une épaisseur généralement inférieure à 3 mm et généralement supérieure à 100 µm pris en sandwich entre deux couches métalliques (la couche du motif conducteur surmontant le substrat diélectrique et l'autre couche conductrice située sous le substrat diélectrique).

A titre illustratif, l'épaisseur de la couche conductrice située sous le substrat sera avantageusement sélectionnée parmi les épaisseurs suivantes.

Dans un mode d'exécution particulier selon la présente invention, la couche conductrice située sous le substrat est caractérisée par une épaisseur de matière conductrice supérieure à 100 nm. On utilisera par exemple une épaisseur de plus de 150 nm. On utilisera par exemple une épaisseur de plus de 200 nm. On utilisera par exemple une épaisseur de plus de 250 nm. On utilisera par exemple une épaisseur de plus de 300 nm. On utilisera par exemple une épaisseur de plus de 400 nm. On utilisera par exemple une épaisseur de plus de 500 nm.

Dans un mode d'exécution particulier selon la présente invention, la couche conductrice située sous le substrat est caractérisée par une épaisseur de matière conductrice inférieure à 20 microns, par exemple inférieure à 10 microns, voire inférieure à 2 microns. On utilisera par exemple une épaisseur de moins de 1,5 microns. On utilisera par exemple une épaisseur de moins de 1 micron.

Dans un mode d'exécution particulier selon la présente invention, le total des couches (motif conducteur - diélectrique - couche conductrice) pourra par exemple avoir une épaisseur de 0,1 à 3mm.

Bien qu'on parle de tag avec ou sans plan de masse, dans la technique, le terme « plan de masse » est bien souvent associé à la couche métallique (située sous le substrat) dont la surface correspond de préférence totalement à celle du substrat.

Dans un mode d'exécution particulier selon la présente invention, la matière de la couche conductrice constituant le plan de masse comprend (ou de préférence consiste en) un matériau choisi dans le groupe consistant en du graphite, du cuivre, du nickel, de l'argent, de l'aluminium, du platine et/ou leurs mélanges, de préférence du cuivre et/ou de l'argent et/ou de l'aluminium. Dans un mode d'exécution particulier selon la présente invention, la matière de la couche conductrice constituant le plan de masse est différente ou identique à celle du motif conducteur, de préférence identique.

La seconde couche métallique (le(s) motif(s)) va-elle être façonnée de manière à présenter une forme géométrique particulière correspondant aux motifs du tag (à l'image de motifs présentés sur la figure 1). Un tag avec plan de masse est donc une structure comportant deux couches métalliques alors que son analogue sans plan de masse va lui comporter une seule couche à savoir celle où le motif du tag est réalisé. Un tag avec plan de masse a l'avantage, une fois positionné côté plan de masse sur un objet, d'isoler d'un point de vue électromagnétique le tag de l'objet. Dans ce cas, l'influence de l'objet sur le tag est moindre par rapport à un tag sans plan de masse.

On note également qu'un tag avec plan de masse est un cas particulier d'un tag comportant deux couches métallisées où le substrat est pris en sandwich. En effet, dans cette configuration préférée, une des deux couches est de préférence entièrement métallisée. Toutefois des configurations intermédiaires de tag sont possibles, on citera par exemple un tag avec plans de masse, où coté plan de masse des ouvertures (retraits de zones métalliques) sont réalisées pour permettre d'atteindre un comportement particulier. Ceci peut par exemple permettre de réaliser de nouvelles résonnances, ou de modifier celles déjà présentes sur la première couche conductrice. Elles peuvent également favoriser l'isolement des différents résonateurs de la seconde couche métallique, améliorant ainsi le découplage de ces résonances et donc ayant un effet qui peut permettre d'améliorer les performances de lecture du tag.

La couche de matière conductrice du plan de masse peut être déposée, de préférence directement sur le substrat diélectrique, par toute méthode de dépôt appropriée. On répétera déjà titre illustratif les méthodes de dépôt mentionnés ci-dessus pour le dépôt des motifs conducteurs.

On note également qu'un tag chipless comportant deux couches conductrices avec au milieu la couche diélectrique, pour des questions de coût peut également être réalisé en entourant le substrat des couches conductrices, par exemple par pliage. Dans ce cas, la couche conductrice peut avoir une surface au moins deux fois supérieure à celle du substrat, typiquement une largeur au moins deux fois supérieurs avec la même longueur. Une fois cette surface comportant les motifs conducteurs et ou le plan de masse fabriquée, elle sera avantageusement reportée en une fois autour de la couche diélectrique. Ceci est possible en la pliant tout autour. La seule différence par rapport à l'approche traditionnelle (report une à une des deux couches métallisées sur chacune des faces du diélectrique) est la présence de la couche métallisée sur un ou plusieurs des flancs du diélectrique. Si cette partie n'est pas métallisée, aucune différence significative n'est présente par rapport à l'approche plus traditionnelle. Toutefois la possibilité de métalliser cette partie (un ou plusieurs flancs du diélectrique) va permettre de réaliser des structures plus complexes, qui à l'image d'une cavité résonante à parois métallique, permettra d'améliorer le facteur de qualité. Ainsi un homme de l'art est en mesure de tirer profit de cette structure qui par ailleurs est généralement plus simple à réaliser car nécessitant moins d'étapes de fabrication. En effet, cette dernière approche réduit le nombre d'étapes technologiques : impression d'un seul support conducteurs, et collage d'un seul support également.

Dans un mode d'application particulier selon la présente invention, on sélectionnera le substrat diélectrique (avec ou sans plan de masse) parmi les matériaux commerciaux utilisés en matière d'isolation thermique ou d'isolation acoustique dont les caractéristiques correspondent à celles revendiquées dans la présente invention ; et on apposera directement sur ces matériaux commerciaux les motifs conducteurs désirés.

La présente invention s'applique donc de manière avantageuse aussi bien aux tags sans plan de masse qu'avec plan de masse.

### Tag dépolarisant

Le tag selon la présente invention sera de préférence caractérisé par le fait qu'il est polarisant ou de préférence dépolarisant. Un tag dépolarisant est un tag capable d'émettre une onde avec une polarisation orientée perpendiculairement à celle incidente (on parle alors de réflexion en polarisation croisée ou cross polarisation en anglais).

Dans un mode d'exécution particulier selon la présente invention, l'étiquette RFID sans puce a un rapport entre la surface supérieure totale du substrat diélectrique et la surface supérieure du substrat diélectrique recouverte de motif(s) constitué(s) d'une couche de matière conductrice supérieur à 2.

Dans un mode d'exécution particulier selon la présente invention, l'étiquette RFID sans puce avec plan de masse a un rapport entre la surface inférieure du substrat diélectrique recouverte de la couche de matière conductrice et la surface inférieure totale du substrat diélectrique supérieur à 0,9.

### Lecteur

A titre illustratif, dans le cadre de la présente invention, le lecteur est un lecteur émetteur-récepteur d'ondes électromagnétiques ; le principe de fonctionnement du dit lecteur repose sur l'émission d'un signal électromagnétique en direction du dispositif d'identification (par exemple l'étiquette) qui va réfléchir le dit signal en fonction de sa géométrie (et par exemple de ses caractéristiques de résonances propres) et sur la capture par le lecteur du dit signal réfléchi - ainsi, le traitement du signal reçu (notamment à travers une étape de décodage) permettra de remonter à l'information contenue dans le dispositif (par exemple, l'étiquette / le tag).

Ainsi, de manière générale, les dispositifs d'identification par fréquence radio sans puce selon la présente invention font partie d'un système RFID qui comprend également un ou plusieurs lecteurs RFID qui sont eux-mêmes connectés on non à des ordinateurs de supervision ou à une carte électronique qui réalise un traitement qui peuvent par exemple faire le lien avec des bases de données existantes. Ces lecteurs permettent donc d'identifier des objets grâce aux tags RFID qui y sont apposés, les dits tags RFID sans puce étant assimilables à une cible radar statique avec une signature électromagnétique spécifique. Ainsi, dans un mode d'exécution particulier de la présente invention, les lecteurs RFID sans puce sont donc assimilables à un radar en termes de fonctionnement, par exemple un radar aérien détectant la signature des avions à un rapport d'échelle et de puissance près. A titre illustratif, les tags RFID sans puce peuvent être vus comme des cibles radar possédant une signature temporelle ou fréquentielle particulière. Tout type de radar approprié à la réception/identification du signal retro-émis par le tag RFID pourra avantageusement être utilisé dans le cadre de l'invention ; à titre illustratif et non limitatif, nous citerons le radar impulsionnel.

Les capacités de codage obtenues au moyen des dispositifs d'identification par fréquence radio sans puce selon la présente invention répondent aux normes en vigueur car les étiquettes obtenues permettent d'avoir au moins 40 bits d'informations ce qui correspond au codes à barre de type EAN13. A titre illustratif, des valeurs de plus de 40 bits pour un format de carte de crédit [soit 40 / (85,60 × 53,98 mm)= 40 /46 bits/cm²] ont été obtenues ; ainsi, dans un mode d'exécution particulier selon la présente invention, les dispositifs revendiqués sont caractérisés par une valeur de capacité de codage supérieure à 0,85 bits/cm², par exemple supérieure à 1 bits/cm², supérieure à 2 bits/cm², voire supérieure à 5 bits/cm².

Dans une variante de réalisation de la présente invention, le tag revendiqué pourra être apposé sur tout type d'objet et/ou d'êtres vivants (par exemple un animal ou un humain). Dans une variante de réalisation de la présente invention, l'objet sur lequel le tag sera apposé (de préférence collé) peut être sélectionné parmi un grand nombre de matières dont nous citerons à titre d'exemples non limitatifs le métal, le papier, le tissu, le plastique, par exemple une résine copolymère méthacrylique, du polyester, du polycarbonate, du polyéthylène, du polypropylène, et/ou du chlorure de polyvinyle, ou même les matériaux de type cellulosique tels que, par exemple, le bois, le contreplaqué ou les matériaux cristallins tels que le verre ou les céramique, par exemple les matériaux complexes comprenant un ou plusieurs de ces composants comme par exemple les briques de lait.

Dans une variante de réalisation de la présente invention et à condition que le substrat diélectrique du tag revendiqué réponde aux exigences d'une ou plusieurs des revendications 1 à 13, ledit substrat diélectrique pourra être sélectionné parmi un grand nombre de matières dont nous citerons à titre d'exemples non limitatifs le papier, le tissu, le plastique, par exemple une résine copolymère méthacrylique, du polyester, du polycarbonate, du polyéthylène, du polypropylène, et/ou du chlorure de polyvinyle, ou même les matériaux de type cellulosique tels que, par exemple, le bois, le contreplaqué ou les matériaux cristallins tels que le verre ou les céramique, par exemple les matériaux complexes comprenant un ou plusieurs de ces composants comme par exemple les briques de lait.

La présente demande décrit diverses caractéristiques techniques et avantages en référence aux Figures et/ou à divers modes de réalisation. L'homme de métier comprendra que les caractéristiques techniques d'un mode de réalisation donné peuvent en fait être combinées avec des caractéristiques d'un autre mode de réalisation à moins que l'inverse ne soit explicitement mentionné ou qu'il ne soit évident que ces caractéristiques sont incompatibles ou que la combinaison ne fournisse pas une solution à au moins un des problèmes techniques mentionnés dans la présente demande. De plus, les caractéristiques techniques décrites dans un mode de réalisation donné peuvent être isolées des autres caractéristiques de ce mode à moins que l'inverse ne soit explicitement mentionné.

Il doit être évident pour les personnes versées dans l'art que la présente invention permet des modes de réalisation sous de nombreuses autres formes spécifiques sans l'éloigner du domaine d'application de l'invention comme revendiqué. Par conséquent, les présents modes de réalisation doivent être considérés à titre d'illustration, mais peuvent être modifiés dans le domaine défini par la portée des revendications jointes, et l'invention ne doit pas être limitée aux détails donnés ci-dessus.

### Exemple

Matériau d'emballage - caractéristiques :
- Film en polymère d'épaisseur de 1 mm
- Masse volumique apparente : 60kg/m³
- Permittivité relative mesurée : 1.036 à 3.21 GHz et 1.035 à 3.89 GHz.
- Tangente de perte mesurée: 1.9 x 10⁻⁵ à 3.21 GHz et 3.7 x 10⁻⁵ à 3.89 GHz.

En utilisant un matériau d'emballage disponible commercialement comme substrat diélectrique et ayant les caractéristiques indiquées ci-dessus, on a réalisé des tags avec plan de masse ayant les caractéristiques suivantes :
- Couche d'aluminium de 10 microns d'épaisseur sous toute la surface du substrat ;
- Motifs conducteurs similaires à ceux de la figure 1, en aluminium et de 10 microns d'épaisseur.

Ces tags sont caractérisés par des identifiants différents et des facteurs de qualité supérieures.

Dans un mode d'exécution particulier selon la présente invention, l'étiquette RFID sans puce sera constituée successivement
- d'une couche conductrice optionnelle mais préférée dont l'épaisseur est comprise entre 200 nm et 20 microns, par exemple inférieure à 10 microns, voire inférieure à 2 microns,
- surmontée d'une pellicule diélectrique optionnelle mais préférée dont l'épaisseur est comprise entre 5 microns et 100 microns,
- surmontée du substrat diélectrique principal (par exemple la mousse solide, le carton mousse, le carton ondulé, le carton alvéolaire et/ou le tissu, de préférence la mousse solide) dont l'épaisseur est comprise entre 0,5 mm et 3 mm,
- surmontée d'une pellicule diélectrique dont l'épaisseur est comprise entre 5 microns et 100 microns sur laquelle est(sont) apposée(s) le(s) motif(s) constitué(s) d'une couche de matière conductrice dont l'épaisseur est comprise entre 200 nm et 20 microns, par exemple inférieure à 10 microns, voire inférieure à 2 microns.

Cette étiquette RFID est également avantageusement caractérisée par des dimensions de largeur et longueur de toutes ses couches (sauf les motifs conducteurs bien évidemment) qui sont proches de ceux d'une carte de crédit ou carte de banque. ; à titre illustratif, ces dimensions seront de préférence comprises entre 86 mm +- 2 mm pour la longueur et 54 +-2 mm pour la largeur (les dimensions plus précises préférées étant de 85,725 × 53,975 mm).

## Revendications

1. Etiquette RFID sans puce comprenant un substrat diélectrique surmonté de motif(s) constitué(s) d'une couche de matière conductrice, le substrat diélectrique ayant une permittivité relative mesurée à toute fréquence comprise entre 3 et 10 GHz comprise entre 1 et 2 et étant **caractérisé par** une valeur de tangente d'angle de perte mesurée à toute fréquence comprise entre 3 et 10 GHz inférieure à 10⁻³.

2. Etiquette RFID sans puce selon la revendication 1 **caractérisée en ce que** le substrat diélectrique a une permittivité relative comprise entre 1,001 et 1,25.

3. Etiquette RFID sans puce selon l'une quelconque des revendications précédentes **caractérisée en ce que** la valeur de tangente d'angle de perte est inférieure à 2.10⁻⁴ .

4. Etiquette RFID sans puce selon l'une quelconque des revendications précédentes **caractérisée en ce que** la masse volumique apparente du substrat diélectrique est inférieure à 250 kg.m⁻³, de préférence inférieure à 100 kg.m⁻³.

5. Etiquette RFID sans puce selon l'une quelconque des revendications précédentes **caractérisée en ce que** le substrat diélectrique est constitué d'un substrat diélectrique principal surmonté d'une pellicule diélectrique, par exemple une feuille de papier, de carton ou de plastique, sur laquelle est(sont) apposé(s) le(s) motif(s) constitué(s) d'une couche de matière conductrice.

6. Etiquette RFID sans puce selon la revendication 5 **caractérisée en ce que** la pellicule diélectrique est **caractérisée par** l'une, deux ou plusieurs des caractéristiques suivantes :
- une permittivité relative mesurée à toute fréquence comprise entre 3 et 10 GHz supérieure à celle du substrat diélectrique principal ; de préférence une permittivité relative supérieure à 1,25 , par exemple supérieure à 2 ; de préférence une permittivité relative inférieure à 3,5 ; et/ou
- une valeur de tangente d'angle de perte mesurée à toute fréquence comprise entre 3 et 10 GHz supérieure à celle du substrat diélectrique principal ; de préférence une valeur de tangente d'angle de perte inférieure à 2.10⁻² ; et/ou
- une épaisseur au moins dix fois inférieure à celle du substrat diélectrique principal ; de préférence une épaisseur inférieure à 100 microns, par exemple inférieure à 50 microns ; et/ou
- constituée de matière plastique, par exemple de polyéthylène, de polypropylène ou de polyéthylène téréphtalate.

7. Etiquette RFID sans puce selon l'une quelconque des revendications précédentes **caractérisée en ce que** la partie supérieure du substrat diélectrique est en contact avec le(s) motif(s) constitué(s) d'une couche de matière conductrice.

8. Etiquette RFID sans puce selon l'une quelconque des revendications précédentes **caractérisée en ce que** l'épaisseur du substrat diélectrique est supérieure à 0,5 mm, par exemple supérieure à 0,75 mm.

9. Etiquette RFID sans puce selon l'une quelconque des revendications précédentes **caractérisée en ce que** l'épaisseur du substrat diélectrique est inférieure à 3 mm, par exemple inférieure à 1,5 mm.

10. Etiquette RFID sans puce selon l'une quelconque des revendications précédentes **caractérisée en ce que** la couche conductrice constituant le motif a une épaisseur de matière conductrice supérieure à 200 nm et inférieure à 20 microns.

11. Etiquette RFID sans puce selon l'une quelconque des revendications précédentes **caractérisée en ce que** la couche conductrice constituant le motif a une épaisseur de matière conductrice supérieure à 400 nm et inférieure à 2 microns.

12. Etiquette RFID sans puce avec plan de masse selon l'une quelconque des revendications précédentes **caractérisée en ce qu'**elle comprend une couche de matière conductrice sous le substrat diélectrique, de préférence sous toute la surface du substrat diélectrique.

13. Etiquette RFID sans puce selon la revendication 12 **caractérisée en ce que** la couche de matière conductrice sous le substrat diélectrique a une épaisseur de matière conductrice supérieure à 200 nm et inférieure à 20 microns.

14. Etiquette RFID sans puce selon l'une quelconque des revendications 12 et 13 **caractérisée en ce que** la couche de matière conductrice sous le substrat diélectrique a une épaisseur de matière conductrice supérieure à 400 nm et inférieure à 2 microns.

15. Etiquette RFID sans puce selon l'une quelconque des revendications précédentes **caractérisée en ce que** le substrat diélectrique est sélectionné parmi les substrats diélectriques en mousse solide, en carton mousse, en carton ondulé, en carton alvéolaire ou en tissu.

16. Etiquette RFID sans puce selon la revendication 15 **caractérisée en ce que** le substrat diélectrique est une mousse solide en polymère.

17. Etiquette RFID sans puce selon la revendication 16 **caractérisée en ce que** le substrat diélectrique est une mousse solide en polymère ayant une densité de bulles comprise entre 10⁴ et 10⁹ bulles/cm³.

18. Etiquette RFID sans puce selon l'une quelconque des revendications précédentes **caractérisée en ce que** le substrat diélectrique est une mousse solide en polymère ayant une taille des bulles dont le diamètre moyen est compris entre 20 microns et 200 microns.

19. Etiquette RFID sans puce selon l'une quelconque des revendications précédentes **caractérisée en ce que** le rapport entre la surface supérieure totale du substrat diélectrique et la surface supérieure du substrat diélectrique recouverte de motif(s) constitué(s) d'une couche de matière conductrice est supérieur à 2.

20. Etiquette RFID sans puce avec plan de masse selon l'une quelconque des revendications 12 à 19 **caractérisée en ce que** le rapport entre la surface inférieure du substrat diélectrique recouverte de la couche de matière conductrice et la surface inférieure totale du substrat diélectrique est supérieur à 0,9.

21. Etiquette RFID sans puce selon l'une quelconque des revendications 5 à 20 **caractérisée en ce qu'**elle est successivement constituée
- d'une couche conductrice,
- surmontée d'une pellicule diélectrique,
- surmontée du substrat diélectrique principal (par exemple la mousse solide, le carton mousse, le carton ondulé, le carton alvéolaire et/ou le tissu, de préférence la mousse solide),
- surmontée d'une pellicule diélectrique sur laquelle est(sont) apposée(s) le(s) motif(s) constitué(s) d'une couche de matière conductrice.

22. Etiquette RFID sans puce selon la revendication 21 **caractérisée en ce que**
- la couche conductrice a une épaisseur comprise entre 200 nm et 20 microns, par exemple inférieure à 10 microns, voire inférieure à 2 microns,
- la couche conductrice est surmontée d'une pellicule diélectrique dont l'épaisseur est comprise entre 5 microns et 100 microns,
- la pellicule diélectrique est surmontée du substrat diélectrique principal (par exemple la mousse solide, le carton mousse, le carton ondulé, le carton alvéolaire et/ou le tissu, de préférence la mousse solide) dont l'épaisseur est comprise entre 0,5 mm et 3 mm,
- le substrat diélectrique principal est surmonté d'une pellicule diélectrique dont l'épaisseur est comprise entre 5 microns et 100 microns sur laquelle est(sont) apposée(s) le(s) motif(s) constitué(s) d'une couche de matière conductrice dont l'épaisseur est comprise entre 200 nm et 20 microns, par exemple inférieure à 10 microns, voire inférieure à 2 microns.

23. Procédé de fabrication d'une étiquette RFID sans puce selon l'une quelconque des revendications 5 à 22 par enveloppement et/ou soudure aux extrémités des couches constitutrices de l'étiquette de manière à les maintenir en contact sans les coller.

## Patentansprüche

1. Chiploses RFID-Etikett, das ein dielektrisches Substrat umfasst, auf dem sich (ein) Muster befinden, das/die aus einer Schicht aus leitfähigem Material bestehen, wobei das dielektrische Substrat eine relative Permittivität zwischen 1 und 2 aufweist, gemessen bei einer beliebigen Frequenz zwischen 3 und 10 GHz, und durch einen Verlustwinkeltangens-Wert von weniger als 10⁻³ gekennzeichnet ist, gemessen bei einer beliebigen Frequenz zwischen 3 und 10 GHz.

2. Chiploses RFID-Etikett nach Anspruch 1, **dadurch gekennzeichnet, dass** das dielektrische Substrat eine relative Permittivität zwischen 1,001 und 1,25 aufweist.

3. Chiploses RFID-Etikett nach einem der vorhergehenden Ansprüche, **dadurch gekennzeichnet, dass** der Verlustwinkeltangens-Wert kleiner als 2.10⁻⁴ ist.

4. Chiploses RFID-Etikett nach einem der vorhergehenden Ansprüche, **dadurch gekennzeichnet, dass** die Rohdichte des dielektrischen Substrats weniger als 250 kg.m⁻³, vorzugsweise weniger als 100 kg.m⁻³ beträgt.

5. Chiploses RFID-Etikett nach einem der vorhergehenden Ansprüche, **dadurch gekennzeichnet, dass** das dielektrische Substrat aus einem dielektrischen Hauptsubstrat besteht, das mit einer dielektrischen Folie bedeckt ist, beispielsweise einem Blatt Papier, Karton oder Kunststoff, auf der das bzw. die Muster, die aus einer Schicht aus leitfähigem Material bestehen, angebracht sind.

6. Chiploses RFID-Etikett nach Anspruch 5, **dadurch gekennzeichnet, dass** die dielektrische Folie durch eine, zwei oder mehrere der folgenden Eigenschaften gekennzeichnet ist:
eine relative Permittivität, gemessen bei einer beliebigen Frequenz zwischen 3 und 10 GHz, die größer ist als die des dielektrischen Hauptsubstrats; vorzugsweise eine relative Permittivität größer als 1,25, beispielsweise größer als 2; vorzugsweise eine relative Permittivität kleiner als 3,5; und/oder
ein Verlustwinkeltangens-Wert, der bei einer beliebigen Frequenz zwischen 3 und 10 GHz gemessen wird und höher ist als der des dielektrischen Hauptsubstrats; vorzugsweise einen Verlustwinkeltangens-Wert von weniger als 2.10⁻²; und/oder
eine Dicke, die mindestens zehnmal geringer ist als die des dielektrischen Hauptsubstrats; vorzugsweise eine Dicke von weniger als 100 Mikrometern, beispielsweise weniger als 50 Mikrometern; und/oder
bestehend aus Kunststoff, beispielsweise Polyethylen, Polypropylen oder Polyethylenterephthalat.

7. Chiploses RFID-Etikett nach einem der vorhergehenden Ansprüche, **dadurch gekennzeichnet, dass** der obere Teil des dielektrischen Substrats mit dem bzw. den Mustern in Kontakt steht, die aus einer Schicht aus leitfähigem Material bestehen.

8. Chiploses RFID-Etikett nach einem der vorhergehenden Ansprüche, **dadurch gekennzeichnet, dass** die Dicke des dielektrischen Substrats größer als 0,5 mm, beispielsweise größer als 0,75 mm ist.

9. Chiploses RFID-Etikett nach einem der vorhergehenden Ansprüche, **dadurch gekennzeichnet, dass** die Dicke des dielektrischen Substrats kleiner als 3 mm, beispielsweise kleiner als 1,5 mm ist.

10. Chiploses RFID-Etikett nach einem der vorhergehenden Ansprüche, **dadurch gekennzeichnet, dass** die das Muster bildende leitfähige Schicht eine Dicke des leitfähigen Materials von mehr als 200 nm und weniger als 20 Mikrometer aufweist.

11. Chiploses RFID-Etikett nach einem der vorhergehenden Ansprüche, **dadurch gekennzeichnet, dass** die das Muster bildende leitfähige Schicht eine Dicke des leitfähigen Materials von mehr als 400 nm und weniger als 2 Mikrometer aufweist.

12. Chiploses RFID-Etikett mit Massefläche nach einem der vorhergehenden Ansprüche, **dadurch gekennzeichnet, dass** es eine Schicht aus leitfähigem Material unter dem dielektrischen Substrat, vorzugsweise unter der gesamten Oberfläche des dielektrischen Substrats, umfasst.

13. Chiploses RFID-Etikett nach Anspruch 12, **dadurch gekennzeichnet, dass** die Schicht aus leitfähigem Material unter dem dielektrischen Substrat eine Dicke des leitfähigen Materials von mehr als 200 nm und weniger als 20 Mikrometer aufweist.

14. Chiploses RFID-Etikett nach einem der Ansprüche 12 und 13, **dadurch gekennzeichnet, dass** die Schicht aus leitfähigem Material unter dem dielektrischen Substrat eine Dicke des leitfähigen Materials von mehr als 400 nm und weniger als 2 Mikrometer aufweist.

15. Chiploses RFID-Etikett nach einem der vorhergehenden Ansprüche, **dadurch gekennzeichnet, dass** das dielektrische Substrat zwischen dielektrischen Substraten aus Vollschaum, Schaumstoffplatten, Wellpappe, Wabenplatten oder Gewebe ausgewählt ist.

16. Chiploses RFID-Etikett nach Anspruch 15, **dadurch gekennzeichnet, dass** das dielektrische Substrat ein fester Polymerschaum ist.

17. Chiploses RFID-Etikett nach Anspruch 16, **dadurch gekennzeichnet, dass** das dielektrische Substrat ein fester Polymerschaum mit einer Blasendichte zwischen 10⁴ und 10⁹ Blasen/cm³ ist.

18. Chiploses RFID-Etikett nach einem der vorhergehenden Ansprüche, **dadurch gekennzeichnet, dass** das dielektrische Substrat ein fester Polymerschaum mit einer Blasengröße mit einem durchschnittlichen Durchmesser zwischen 20 Mikrometern und 200 Mikrometern ist.

19. Chiploses RFID-Etikett nach einem der vorhergehenden Ansprüche, **dadurch gekennzeichnet, dass** das Verhältnis zwischen der gesamten oberen Oberfläche des dielektrischen Substrats und der oberen Oberfläche des dielektrischen Substrats, die mit einem Muster bzw. Mustern bedeckt ist, die aus einer Schicht aus leitfähigem Material bestehen, größer als 2 ist.

20. Chiploses RFID-Etikett mit Massefläche nach einem der Ansprüche 12 bis 19, **dadurch gekennzeichnet, dass** das Verhältnis zwischen der Unterseite des dielektrischen Substrats, die mit der Schicht aus leitfähigem Material bedeckt ist, und der gesamten Unterseite des dielektrischen Substrats größer als 0,9 ist.

21. Chiploses RFID-Etikett nach einem der Ansprüche 5 bis 20, **dadurch gekennzeichnet, dass** es sukzessive
aus einer leitfähigen Schicht besteht,
mit einer dielektrischen Folie bedeckt ist,
vom dielektrischen Hauptsubstrat (z. B. festem Schaumstoff, Schaumstoffplatte, Wellpappe, Wabenplatte und/oder Gewebe, vorzugsweise festem Schaumstoff) bedeckt ist,
von einer dielektrischen Folie bedeckt ist, auf der das bzw. die Muster, bestehend aus einer Schicht aus leitfähigem Material, angebracht sind.

22. Chiploses RFID-Etikett nach Anspruch 21, **dadurch gekennzeichnet, dass**
die leitfähige Schicht eine Dicke zwischen 200 nm und 20 Mikrometern aufweist, beispielsweise weniger als 10 Mikrometer oder sogar weniger als 2 Mikrometer,
die leitfähige Schicht ist mit einer dielektrischen Folie bedeckt ist, deren Dicke zwischen 5 und 100 Mikrometern liegt,
die dielektrische Folie mit dem dielektrischen Hauptsubstrat (z. B. fester Schaumstoff, Schaumstoffplatte, Wellpappe, Wabenplatte und/oder Gewebe, vorzugsweise fester Schaumstoff) mit einer Dicke zwischen 0,5 mm und 3 mm bedeckt ist,
das dielektrische Hauptsubstrat mit einer dielektrischen Folie bedeckt ist, deren Dicke zwischen 5 und 100 Mikrometern liegt, auf der das Muster bzw. die Muster befestigt sind, die aus einer Schicht aus leitfähigem Material bestehen, deren Dicke zwischen 200 nm und 20 Mikrometern, beispielsweise weniger als 10 Mikrometer oder sogar weniger als 2 Mikrometer beträgt.

23. Verfahren zur Herstellung eines chiplosen RFID-Etikett nach einem der Ansprüche 5 bis 22 durch Umwickeln und/oder Verschweißen der Enden der Schichten, aus denen das Etikett besteht, um sie in Kontakt zu halten, ohne sie zu verkleben.

## Claims

1. Chipless RFID tag comprising a dielectric substrate on which a pattern or patterns are mounted consisting of a layer of conductive material, the dielectric substrate having a relative permittivity measured at any frequency between 3 and 10 GHz of between 1 and 2 and being **characterised by** a loss tangent value measured at any frequency between 3 and 10 GHz of less than 10⁻³.

2. Chipless RFID tag according to claim 1 **characterised in that** the dielectric substrate has a relative permittivity between 1.001 and 1.25.

3. Chipless RFID tag according to any one of the preceding claims **characterised in that** the loss tangent value is less than 2.10⁻⁴.

4. Chipless RFID tag according to any one of the preceding claims **characterised in that** the bulk density of the dielectric substrate is less than 250 kg.m⁻³, preferably less than 100 kg.m⁻³.

5. Chipless RFID tag according to any one of the preceding claims **characterised in that** the dielectric substrate is composed of a main dielectric substrate on which a dielectric film is mounted, for example a sheet of paper, cardboard or plastic, on which are placed the pattern or patterns composed of a layer of conductive material.

6. Chipless RFID tag according to claim 5 **characterised in that** the dielectric film is **characterised by** one, two or more of the following characteristics:
- a relative permittivity measured at any frequency between 3 and 10 GHz greater than that of the main dielectric substrate, preferably a relative permittivity greater than 1.25, for example greater than 2, preferably a relative permittivity less than 3.5, and/or
- a loss tangent value measured at any frequency between 3 and 10 GHz greater than that of the main dielectric substrate, preferably a loss tangent value less than 2.10⁻², and/or
- a thickness at least ten times less than that of the main dielectric substrate, preferably a thickness of less than 100 microns, for example less than 50 microns; and/or
- composed of plastic material, for example polyethylene, polypropylene or polyethylene terephthalate.

7. Chipless RFID tag according to any one of the preceding claims **characterised in that** the upper part of the dielectric substrate is in contact with the pattern or patterns consisting of a layer of conductive material.

8. Chipless RFID tag according to any one of the preceding claims **characterised in that** the thickness of the dielectric substrate is greater than 0.5 mm, for example greater than 0.75 mm.

9. Chipless RFID tag according to any one of the preceding claims **characterised in that** the thickness of the dielectric substrate is less than 3 mm, for example less than 1.5 mm.

10. Chipless RFID tag according to any one of the preceding claims **characterised in that** the conductive layer constituting the pattern has a conductive material thickness greater than 200 nm and less than 20 microns.

11. Chipless RFID tag according to any one of the preceding claims **characterised in that** the conductive layer constituting the pattern has a conductive material thickness greater than 400 nm and less than 2 microns.

12. Chipless RFID tag with ground plane according to any one of the preceding claims **characterised in that** it comprises a layer of conductive material under the dielectric substrate, preferably under the entire surface of the dielectric substrate.

13. Chipless RFID tag according to claim 12 **characterised in that** the layer of conductive material under the dielectric substrate has a conductive material thickness greater than 200 nm and less than 20 microns.

14. Chipless RFID tag according to any one of the claims 12 and 13 **characterised in that** the layer of conductive material under the dielectric substrate has a conductive material thickness greater than 400 nm and less than 2 microns.

15. Chipless RFID tag according to any one of the preceding claims **characterised in that** the dielectric substrate is selected from dielectric substrates made from solid foam, foam board, corrugated cardboard, cellular cardboard or fabric.

16. Chipless RFID tag according to claim 15 **characterised in that** the dielectric substrate is a solid polymer foam.

17. Chipless RFID tag according to claim 16 **characterised in that** the dielectric substrate is a solid polymer foam having a bubble density of between 10⁴ and 10⁹ bubbles/cm³.

18. Chipless RFID tag according to any one of the preceding claims **characterised in that** the dielectric substrate is a solid polymer foam having a bubble size the average diameter of which is between 20 microns and 200 microns.

19. Chipless RFID tag according to any one of the preceding claims **characterised in that** ratio between the total upper surface of the dielectric substrate and the upper surface of the dielectric substrate covered with the pattern(s) consisting of a layer of conductive material, is greater than 2.

20. Chipless RFID tag with a ground plane according to any one of the claims 12 to 19 **characterised in that** the ratio between the lower surface of the dielectric substrate covered with the layer of conductive material and the total lower surface of the dielectric substrate, is greater than 0.9.

21. Chipless RFID tag according to any one of the claims 5 to 20 **characterised in that** it is successively constituted:
- of a conductive layer,
- on which a dielectric film is mounted,
- on which the main dielectric substrate is mounted (for example solid foam, foam board, corrugated cardboard, cellular cardboard and/or fabric, preferably solid foam)
- on which a dielectric film is mounted on which the pattern or patterns composed of a layer of conductive material are placed.

22. Chipless RFID tag according to claim 21 **characterised in that**
- the conductive layer has a thickness of between 200 nm and 20 microns, for example less than 10 microns, or even less than 2 microns,
- on the conductive layer is mounted a dielectric film the thickness of which is between 5 microns and 100 microns,
- on the dielectric film is mounted the main dielectric substrate (for example solid foam, foam board, corrugated cardboard, cellular cardboard and/or fabric, preferably solid foam) the thickness of which is between 0.5 mm and 3 mm,
- on the main dielectric substrate is mounted a dielectric film the thickness of which is between 5 microns and 100 microns and on which the pattern or patterns composed of a layer of conductive material are placed the thickness of which is between 200 nm and 20 microns, for example less than 10 microns, or even less than 2 microns.

23. Manufacturing process of a chipless RFID tag according to any one of the claims 5 to 22 by wrapping or welding at the extremity of the layers making up the tag so as to keep them in contact without glueing them.
